Europäisches Patentamt

European Patent Office

Office européen des brevets

(19)

(11) **EP 1 202 100 A2**

(12) **EUROPÄISCHE PATENTANMELDUNG**

(43) Veröffentlichungstag:
   **02.05.2002 Patentblatt 2002/18**

(51) Int Cl.7: **G02B 19/00**, G03F 7/20

(21) Anmeldenummer: **01121888.0**

(22) Anmeldetag: **12.09.2001**

(84) Benannte Vertragsstaaten:
   **AT BE CH CY DE DK ES FI FR GB GR IE IT LI LU MC NL PT SE TR**
   Benannte Erstreckungsstaaten:
   **AL LT LV MK RO SI**

(30) Priorität: **27.10.2000 DE 10053587**
   **05.01.2001 DE 20100123 U**

(71) Anmelder: **Carl Zeiss**
   **89518 Heidenheim (Brenz) (DE)**

(72) Erfinder:
   • **Singer, Wolfgang, Dr.**
     **73431 Aalen (DE)**
   • **Ulrich, Wilhelm**
     **73434 Aalen (DE)**
   • **Antoni, Martin**
     **73434 Aalen (DE)**

(74) Vertreter: **Dr. Weitzel & Partner**
   **Friedenstrasse 10**
   **89522 Heidenheim (DE)**

(54) **Beleuchtungssystem mit reduzierter Wärmebelastung**

(57)   Die Erfindung betrifft ein Beleuchtungssystem für Wellenlängen ≤ 193 nm, insbesondere für die EUV-Lithographie, mit

- einer Lichtquelle;
- einem ersten optischen Element mit ersten Rasterelementen, das durch die Lichtquelle ausgeleuchtet wird und daß das von der Lichtquelle her einfallende Lichtbündel in konvergente Lichtbüschel ,mit je einem Fokuspunkt zerlegt;
- einem zweiten optischen Element mit zweiten Rasterelementen, wobei jedem Lichtbüschel, welches vom ersten Rasterelement ausgebildet wird, ein zweites Rasterelement zugeordnet ist;

Die Erfindung ist dadurch gekennzeichnet, daß

- die zweiten Rasterelemente des zweiten optischen Elementes außerhalb des Fokuspunktes des von den ersten Rasterelementen des ersten optischen Elementes erzeugten Strahlbüschels liegen.

Fig.1

## Beschreibung

Die Erfindung betrifft ein Beleuchtungsssytem gemäß dem Oberbegriff des Anspruches 1, ein Verfahren zur Reduzierung der Wärmebelastung sowie eine Projektionsbelichtungsanlage mit einem derartigen Beleuchtungssystem.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern. Denkbar ist bei Wellenlängen kleiner als 193 nm beispielsweise die Lithographie mit weichen Röntgenstrahlen, sog. EUV-Lithographie.

Ein für die EUV-Lithographie geeignetes Beleuchtungssystem soll mit möglichst wenigen Reflektionen das für die EUV-Lithographie vorgegebene Feld, insbesondere das Ringfeld eines Objektivs homogen, d.h. uniform ausleuchten, des weiteren soll die Pupille des Objektives feldunabhängig bis zu einem bestimmten Füllgrad σ ausgeleuchtet werden und die Austrittspupille des Beleuchtungssystems in der Eintrittspupille des Objektivs liegen.

Aus der US 5,339,346 ist ein Beleuchtungssystem für eine Lithographieeinrichtung, die EUV-Strahlen verwendet, bekanntgeworden. Zur gleichmäßigen Beleuchtung in der Retikelebene und Füllung der Pupille schlägt die US 5,339,346 einen Kondensor vor, der als Kollektorlinse aufgebaut ist und wenigstens vier paarweise Spiegelfacetten, die symmetrisch angeordnet sind, umfaßt. Als Lichtquelle wird eine Plasma-Lichtquelle verwendet.

In der US 5,737,137 ist ein Beleuchtungssystem mit einer Plasma-Lichtquelle umfassend einen Kondensorspiegel, gezeigt, bei dem mit Hilfe von sphärischen Spiegeln eine Ausleuchtung einer zu beleuchtenden Maske bzw. eines Retikels erzielt wird.

Die US 5,361,292 zeigt ein Beleuchtungssystem, bei dem eine Plasma-Lichtquelle vorgesehen ist und die punktförmige Plasma-Lichtquelle mit Hilfe eines Kondensors, der fünf asphärische, außermittig angeordnete Spiegel aufweist, in eine ringförmig ausgeleuchtete Fläche abgebildet wird. Mit Hilfe einer speziellen nachgeordneten Abfolge von grazing-incidence-Spiegeln wird die ringförmig ausgeleuchtete Fläche dann in die Eintrittspupille abgebildet.

Aus der US 5,581,605 ist ein Beleuchtungssystem bekanntgeworden, bei dem ein Photonenstrahler mit Hilfe eines Wabenkondensors in eine Vielzahl von sekundären Lichtquellen aufgespalten wird. Hierdurch wird eine gleichmäßige bzw. uniforme Ausleuchtung in der Retikelebene erreicht. Die Abbildung des Retikels auf den zu belichtenden Wafer erfolgt mit Hilfe einer herkömmlichen Reduktionsoptik. Im Beleuchtungsstrahlengang ist genau ein gerasterter Spiegel mit gleich gekrümmten Elementen vorgesehen.

Die EP 0 939 341 zeigt ein Köhler sches Beleuchtungssystem für Wellenlängen < 200 nm, insbesondere auch für den EUV-Bereich, mit einem ersten optischen Integrator umfassend eine Vielzahl von ersten Rasterelementen und einem zweiten optischen Integrator, umfassend eine Vielzahl von zweiten Rasterelementen.

Aus der DE 199 03 807 A1 ist ein weiteres EUV-Beleuchtungssystem bekanntgeworden, das zwei Spiegel oder Linsen mit Rasterelementen umfaßt. Derartige Systeme werden auch als doppel facettierte EUV-Beleuchtungssysteme bezeichnet. Der Offenbarungsgehalt dieser Anmeldung wird in die vorliegende Anmeldung vollumfänglich mit aufgenommen.

In der DE 199 03 807 A1 ist der prinzipielle Aufbau eines doppelt facettierten EUV-Beleuchtungssystems, gezeigt. Die Ausleuchtung in der Austrittspupille des Beleuchtungssystems gemäß der DE 199 03 807 wird durch die Anordnung der Rasterelemente auf dem zweiten Spiegel bestimmt.

Ein Nachteil des aus der DE 199 03 807 bekannten Systems ist, daß mit der Feldwabe die Lichtquelle mit einem Durchmesser X direkt in die Pupillenwabe abgebildet wird. Am Ort der Pupillenwabe entsteht im Idealfall ein stigmatisches Abbild der Lichtquelle. Bei kleiner Etendue der Lichtquelle entstehen dann sehr kleine Lichtquellenbilder auf den Pupillenwaben, so daß dort eine lokal stark konzentrierte, sehr hohe Thermallast auftritt.

Allgemein ist die Etendue oder das Phasenraumvolumen der Beleuchtungsoptik gegeben durch

$$(E) \qquad \text{Etendue} = BX \cdot BY \cdot \pi \cdot \sigma^2 \cdot NA^2$$

wobei

BX:     Feldbreite
BY:     Feldlänge
NA:     objektseitige Apertur des nachgeschalteten Abbildungsobjektives
σ:      Kohärenzgrad

Mit typischen Werten von $BX \cdot BY = 8 \times 88$ mm$^2$, NA = 0.0625 und σ = 0,8 folgt eine Etendue von E = 5.5 mm$^2$. EUV-Lichtquellen wie zum Beispiel eine Synchrotron Lichtquelle haben eine Etendue von etwa 0.001, also einen Faktor 5500 geringer. Diesbezüglich wird beispielsweise auf M. Antoni et al. "Illumination optics design for EUV lithography", Proc. SPIE, Vol. 4146, pp. 25 - 34 (2000) verwiesen. Bei derartigen Systemen verteilt sich die Thermallast auf punktförmige Lichtquellenbilder auf der Pupillenwabenplatte, wobei die gesamte Leistung nur durch die Anzahl der Facettenspiegel geringfügig reduziert wird.

Aufgabe der Erfindung ist es, ein möglichst einfach aufgebautes doppelt facettiertes Beleuchtungssystem, das eine reduzierte Wärmebelastung auf dem zweiten Spiegel oder der zweiten Linse mit Rasterelementen aufweist sowie ein Verfahren zur Reduzierung der Wärmebelastung auf dem zweiten Spiegel mit Rasterelementen bei einem derartigen Beleuchtungssystem anzugeben.

Erfindungsgemäß wird die Aufgabe dadurch gelöst, daß bei dem oberbegrifflichen Beleuchtungssystem, wie es beispielsweise aus der DE 199 03 807 A1 bekannt geworden ist, durch Verschieben der Rasterelemente des zweiten Spiegels oder der zweiten Linse aus dem Fokus des Lichtbüschels der Rasterelemente des ersten Spiegels oder ersten Linse mit Rasterelementen die Wärmebelastung verringert wird. Über die Divergenz der Lichtbüschel verbreitert sich das Lichtbüschel mit zunehmender Entfernung aus dem Fokuspunkt oder der sekundären Lichtquellenbildlage.

Da der Büscheldurchmesser proportional des Öffnungswinkels des Büschels wächst, gilt:

$$\Delta D = 2\Delta z \cdot \tan(\alpha) \approx 2\Delta z \cdot \sin(\alpha) \approx 2\Delta z \cdot NA$$

mit

$\Delta D =$     Änderung des Büscheldurchmessers
$\Delta z =$     Defokussierung der Pupillenwabe
$\alpha =$     halber Öffnungswinkel des Büschels
$NA =$     numerische Apertur des Büschels

Für ein Büschel mit Durchmesser D(z=0)=X gilt

$$D(z) \approx X + 2\Delta z \cdot NA$$

Möchte man einen vorbestimmten Füllgrad der zweiten Rasterelemente des zweiten Speigels, der sogenannten Pupillenwaben erreichen, so beträgt der Betrag der Defokussierung:

$$\Delta z \approx \frac{Füllgrad_{Ziel} \phi \cdot Pupillenwabe - X}{2 \cdot NA} = \frac{Füllgrad_{Ziel} - Füllgrad_{z=0}}{2 \cdot NA} \phi_{Pupillenwabe}$$

Eine Defokussierung $\Delta z$ kann man durch eine Änderung der Brechkraft der ersten Rasterelemente erreichen oder durch eine Verschiebung der zweiten Rasterelemente, wobei im letzeren Falle auch noch andere Systemdaten angepaßt werden müssen. Die Defokussierung kann bis zu einem derartigen Grad erfolgen, als die Ausleuchtung die zweiten Rasterelemente nicht überstrahlt.

In einer weiteren vorteilhaften Ausführungsform wird zur Erzielung einer besonders geringen lokalen Wärmebelastung der Betrag der Defokussierung so festgesetzt, daß die Ausdehnung der sekundären Lichtquellen kleiner ist als die Größe der Pupillenwaben, wobei die Breite des unbeleuchteten Randbereiches kleiner als 10 % des minimalen Durchmesser der Pupillenwaben ist. Ein unbeleuchteter Bereich liegt dann vor, wenn die Intensität in diesem Bereich < 10 % der maximalen Intensität der sekundären Lichtquelle ist.

Durch eine Änderung der Auftreffpunkte der von der Lichtquelle zur Austrittspupille durchgehenden Lichtkanäle kann in einer weitergebildeten Ausführungsform eine vorgegebene Ausleuchtung in der Austrittspupille eingestellt werden. Durch eine derartige Einstellung der Lichtverteilung in der Austrittspupille können beliebige Verteilungen realisiert werden und Lichtverluste, wie sie beispielsweise bei Lösungen mit Blenden auftreten, werden vermieden.

Bei den erfindungsgemäßen Systemen mit zwei optischen Elementen mit Rasterelementen ist die Form der Pupillenwaben an die Form der sekundären Lichquellen angepaßt und somit verschieden von der Form der ersten Feldwaben. Besonders bevorzugt sind die Pupillenwaben elliptisch oder rund, wenn auch die Lichtquelle rund ausgebildet ist.

In einer bevorzugten Ausführungsform sind den Spiegeln mit Rasterelementen weitere optische Elemente wie Feldspiegel nachgeordnet, die dazu dienen, die Pupillenebene in die Austrittspupille des Beleuchtungssystems, die mit der Eintrittspupille des Projektionsobjektives zusammenfällt, abzubilden und das Ringfeld zu formen.

Besonders bevorzugt ist es, wenn die optischen Elemente grazing-incidence-Spiegel mit Inzidenzwinkel $\leq$ 15° umfassen. Um die mit jeder Reflektion verbundenen Lichtverluste zu minimieren, ist mit Vorteil vorgesehen, wenn die Anzahl der Feldspiegel gering gehalten wird. Besonders bevorzugt sind Ausführungsformen mit höchstens drei Feldspiegeln.

Als Lichtquellen für die EUV-Strahlung sind Laser-Plasma, Plasma oder Pinch-Plasma-Quelle sowie andere EUV-Lichtquellen denkbar.

Andere EUV-Lichtquellen sind beispielsweise Synchrotronstrahlungsquellen. Synchronstrahlung wird emittiert, wenn relativitische Elektronen in einem Magnetfeld abgelenkt werden. Die Synchrotron-Strahlung wird tangential zur Elektronenbahn emittiert.

Nachfolgend soll die Erfindung anhand der Zeichungen beschrieben werden.

Es zeigen:

Figur 1: eine Prinzipskizze zur Herleitung der Formeln für eine Defokussierung mittels Brechkraftänderung der ersten Rasterelemente in refraktiver Darstellung.

Figur 2: Füllung der Pupillenwabe ohne Defokussierung.

Figur 3: Füllung der Pupillenwabe mit Defokussierung.

Figur 4: eine Prinzipskizze eines Beleuchtungssystems.

Figur 5: eine Prinzipskizze eines Projektionsbelichtungssystems

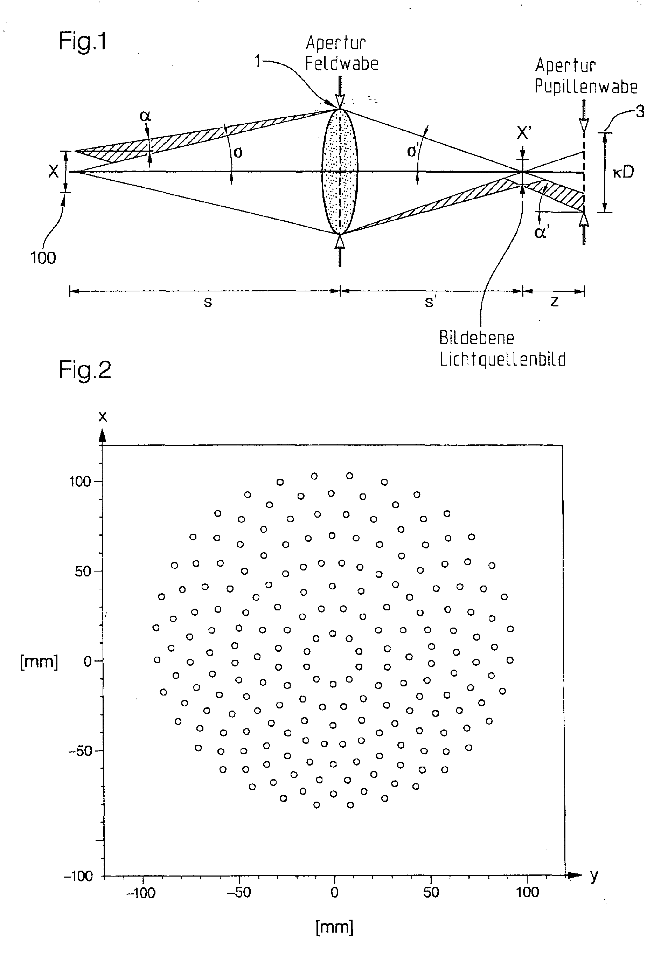

In Figur 1 ist eine Prinzipskizze zur Herleitung der Formeln für eine Defokussierung durch Brechkraftänderung der ersten Rasterelemente gezeigt. Figur 1 ist in refraktiver Darstellung gezeigt. Ein Fachmann kann, ohne erfinderisch tätig zu werden, die Parameter auf die für Belichtungssysteme mit Wellenlängen $\leq$ 193 nm, insbesondere für die EUV-Lithographie notwendigen refraktiven Optiken übertragen.

Soll ein zweites Rasterelement, eine sogenannte Pupillenwabe 3 der Größe D bis zu einem Verhältnis $\kappa$ bei gegebenem Durchmesser X der Lichtquelle gefüllt werden, so muß der Abstand zwischen Pupillenwabe 3 und Feldwabe 1 L = s' + z geeignet gewählt werden. Es gilt:

$$(1) \qquad \beta = \frac{s'}{s} = \frac{X'}{X} = \frac{\sin \sigma}{\sin \sigma'}$$

Dabei ist die Größe des ersten Rasterelementes, der sogenannten Feldwabe 1, durch den Abbildungsmaßstab des nachfolgenden Abbildungssystems bestimmt. Für eine Feldwabengröße von zum Beispiel FX x FY = 2.8 mm x 46 mm folgt für den Aperturwikel $\sigma$:

$$(2) \qquad \tan \sigma_x = \frac{FX}{2s} \ und \ \tan \sigma_y = \frac{FY}{2s}$$

Für die weitere Ableitung wird nur die y-Komponente benötigt, da diese einen großen Divergenzwinkel aufweist. Des weiteren kann $\tan\sigma \sim \sin\sigma$ gesetzt werden. Die Brechkraft der Feldwabe aufgrund der Definition kann wie folgt bestimmt werden.

Die bekannte Abbildungsgleichung erster Ordnung lautet:

$$(3) \ p_1 = -\frac{1}{f} \ x_0 + \frac{1}{\beta} \ p_0$$

wobei:

$p_1$: optischer Richtungskosinus im Bildraum der Feldwabe
$p_2$: optischer Richtungskosinus im Objektraum der Feldwabe
f: Brennweite der Feldwabe
$\beta$: Abbildungsmaßstab der Feldwabe

Der objektseitige optische Richtungskosinus $p_0$ des oberen Aperturstrahls des oberen Lichtquellenrandes X/2 ist gegeben durch:

EP 1 202 100 A2

$$(4) \qquad p_0 = \sin\alpha \approx \tan\alpha = -\frac{(FY-X)}{2s}$$

und der bildseitige optische Richtungskosinus $p_1$ des zugeordneten unteren Randstrahls des Bildes des oberen Lichtquellenrandes ist gegeben durch:

$$(5) \qquad p_1 = \sin\alpha' \approx \tan\alpha' = -\frac{FY + \kappa \cdot D}{2L}$$

Wenn s, L, D und X vorgegeben sind, so bestimmt sich die Brechkraft der Feldwabe wie folgt.

Mit dem Abbildungsmaßstab als Funktion der Brennweite und Schnittweite

$$(6) \qquad \beta = \frac{f}{f + s}$$

folgt

$$(7) \qquad p_1 = -\frac{1}{f} x_0 + \frac{f + s}{f} p_0$$

Auflösen nach f und Einsetzen von Gl. (a) und (5) liefert mit $x_0 = X / 2$

$$(8) \qquad f = \frac{FY \cdot s \cdot L}{(FY + \kappa D)s - (FY-X)L}$$

Mit den Werten

s = 1200 mm
L = 900 mm
D = 10 mm
X = 3 mm
$\kappa$ = 0,8 mm

für s, L, D, X, $\kappa$

folgt

f = 480,092 mm
R $\sim$ -2f = -960.184 mm
z = 99.744 mm

Figur 2 zeigt die Ausleuchtung der Pupillenwabenplatte bei einer Quellgröße von 3 mm bei einer als sphärisch angenommenen Quelle ohne Defokussierung. Die Brennweite der Feldwaben ist f = 514.286 mm, R =-1028.571 mm.

Die aufgenommene Apertur beträgt 0.09. Die Etendue ist entsprechend

$$(9) \quad E = \pi / 4 \cdot X^2 \cdot \pi \, NA^2 \approx 0.2$$

Die Etendue der Lichtquelle entspricht damit etwa dem 25. Teil der Etendue, welche aufgenomen weden könnte. Gleichzeitig füllen die sekundären Lichtquellen nur etwa 1/25 der Pupillenwabenplatte.

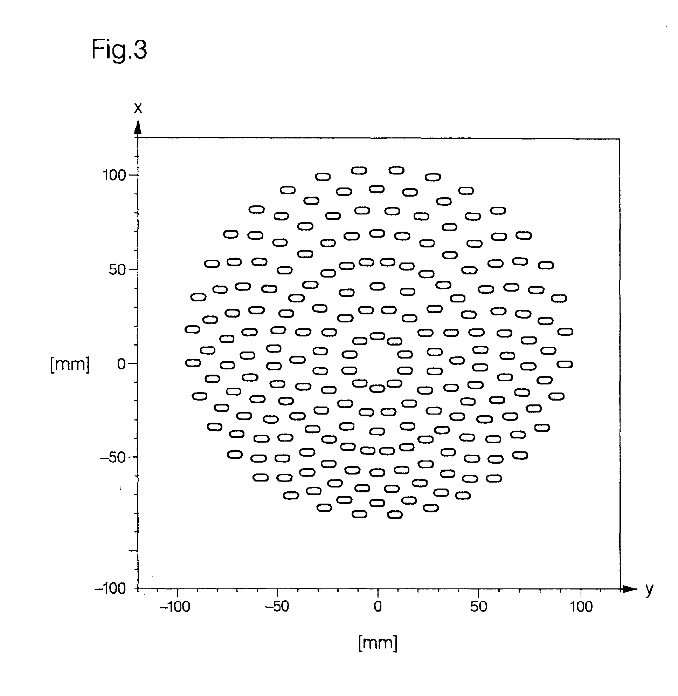

Figur 3 zeigt die Ausleuchtung der Pupillenwabenplatte mit defokussierten sekundären Lichtquellen bei einer Quellgröße von X = 3 mm Durchmesser und einer aufgenommenen Apertur von NA $\sim$ 0.09. Die Etendue ist gleichgeblieben, jedoch hat man eine leichte Abweichung von der Köhler'schen Beleuchtung eingeführt. In die lange Richtung der Feldwaben ,y-Richtung, ist die Ausleuchtung deutlich vergrößert, so daß die Thermallast drastisch reduziert ist. Auch in der kurzen Richtung, x-Richtung, ergibt sich eine Vergrößerung der Lichtquellenbilder. Die Vergrößerung ist jedoch aufgrund des geringen Aperturwinkels geringer.

In einer weitergebildeten Ausführungsform sind die Brechkräfte der Feldwaben an die Abstände der entsprechenden Pupillenwaben angepaßt. Wie man in Fiugr 3 sieht, ist insbesondere in den äußeren Bereichen und in der oberen Hälfte mehr Platz zwischen den Pupillenwaben, welche die jeweiligen einzelnen LIchtquellenbilder aufnehmen,

da die Pupillenwaben wegen der Verzeichnung der nachfolgenden Abbildungsoptik auf einem leicht verzeichnetem Raster angeordnet sind. Über unterschiedliche Defokussierung, d.h. unterschiedliche Brennweiten der einzelnen Feldwaben, lassen sich damit die Lichtquellenbildgrößen individuell beeinflussen.

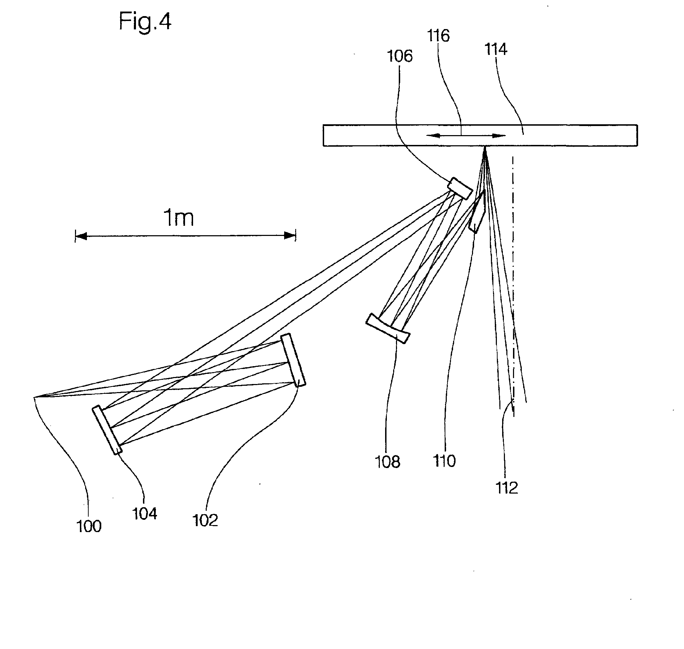

In Figur 4 ist in einer Prinzipansicht ein Beleuchtungssystem, bei dem die Erfindung zur Anwendung kommen kann, gezeigt. Das Beleuchtungssystem umfaßt eine Lichtquelle oder ein Zwischenbild einer Lichtquelle 100. Das von der Lichtquelle bzw. dem Zwischenbild der Lichtquelle 100 ausgesandte Licht, von dem nur drei repräsentative Strahlen gezeichnet sind, trifft auf einen Spiegel 102 mit einer Vielzahl von ersten Rasterelementen, sogenannten Feldwaben. Der Spiegel 102 wird daher auch als Feldwabenspiegel bezeichnet. Die Brechkraft der einzelnen Feldwaben ist gemäß der Erfindung so gewählt, daß eine Defokussierung vorliegt, so daß die zweiten Rasterelemente, die sogenannten Pupillenwaben des zweiten optischen Elementes 104, außerhalb des Fokuspunktes des von den ersten Rasterelementen erzeugten Strahlbüschels liegt. Die dem zweiten optischen Element mit Rasterelementen 104 nachgeordneten optischen Elemente 106, 108 und 110 dienen im wesentlichen dazu, das Feld in der Retikelebene 114 zu formen. Das Retikel in der Retikelebene ist eine Reflexionsmaske. Das Retikel ist in dem als Scanning-System ausgelegten EUV-Projektionssystem in die eingezeichnete Richtung 116 verfahrbar.

Mit Hilfe des in Figur 4 gezeigten Beleuchtungssystem wird die Austrittspupille 112 des Beleuchtungssystems weitgehend homogen ausgeleuchtet. Die Austrittspupille 112 fällt mit der Eintrittspupille eines nachfolgenden Projektionsobjektives zusammen. Ein derartiges Projektionsobjektiv, beispielsweise mit sechs Spiegeln ist in der US-Patentanmeldung 09/503640 gezeigt, deren Offenbarungsgehalt in vorliegende Anmeldung vollumfänglich mitaufgenommen wird.

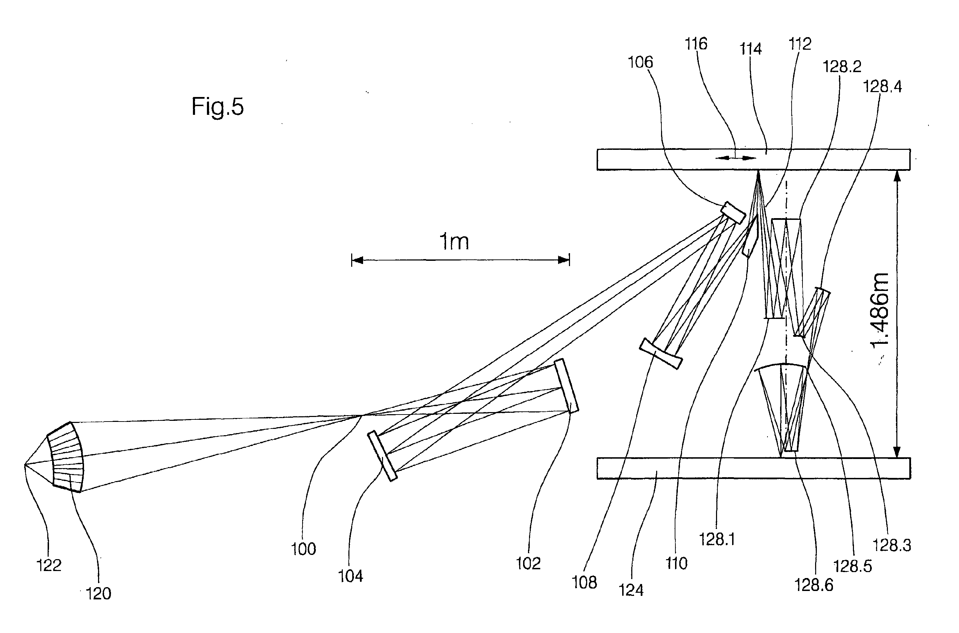

In Figur 5 ist der optische Teil eines Projektionsbelichtungssystems ausgehend von der physikalischen Lichtquelle 122 bis zum zu belichtenden Objekt 124 dargestellt. Gleiche Bauteile wie in Figur 4 sind mit denselben Bezugsziffern belegt. Das System gemäß Figur 5 umfasst die physikalische Lichtquelle 122, einen genesteten Kollektor 120, das Beleuchtungssystem aus Fig.4, ein Projektionsobjektiv 126 beispielsweise mit sechs Spiegeln 128.1, 128.2, 128.3,128.4,128.5,128.6 gemäß der US-Patentanmeldung 09/503640 sowie das zu belichtende Objekt 124.

Mit der Erfindung wird erstmals ein EUV-Beleuchtungssystem angegeben, mit dem die Thermallast auf dem zweiten facettierten Spiegelelement verringert werden kann.

**Patentansprüche**

1.  Beleuchtungssystem für Wellenlängen ≤ 193 nm, insbesondere für die EUV-Lithographie, mit

    1.1 einer Lichtquelle (100);

    1.2 einem ersten optischen Element (102) mit ersten Rasterelementen (1), das durch die Lichtquelle (100) ausgeleuchtet wird und daß das von der Lichtquelle her einfallende Lichtbündel durch die ersten Rasterelemente (1) in konvergente Lichtbüschel mit je einem Fokuspunkt zerlegt wird;

    1.3 einem zweiten optischen Element (104) mit zweiten Rasterelementen (3), wobei jedem Lichtbüschel, welches vom ersten Rasterelement (1) ausgebildet wird, ein zweites Rasterelement (3) zugeordnet ist; **dadurch gekennzeichnet, daß**

    1.4 die zweiten Rasterelemente (3) außerhalb des Fokuspunktes des von den ersten Rasterelementen (1) erzeugten Strahlbüschels liegt.

2.  Beleuchtungssystem nach Anspruch 1,
    **dadurch gekennzeichnet, daß**
    die konvergenten Lichtbüschel eine numerische Apertur NA aufweisen, wobei das Lichtbüschel im Fokuspunkt einen Durchmesser X' aufweist und das außerhalb des Fokuspunktes angeordnete zweite Rasterelement (3) mit dem Durchmesser D eine Defokussierung Δz aufweist, wobei die Defokussierung Δz gegeben ist durch:

$$\frac{0.1\,D\text{-}X'}{2\cdot NA} < \Delta z < \frac{D\text{-}X'}{2\cdot NA}$$

3.  Beleuchtungssystem nach einem der Ansprüche 1 bis 2,
    **dadurch gekennzeichnet, daß**
    bei vorgegebenem Abstand s des ersten optischen Elementes (102) von der Lichtquelle (100), bei vorgegebenem Abstand L zwischen dem ersten optischen Element (102) und dem zweiten optischen Element (104), bei vorgegebenem Durchmesser X der Lichtquelle und Durchmesser D eines zweiten Rasterelementes (3), die Brennweite des zugeordneten ersten Rasterelementes (1) mit einer Ausdehnung FY, wobei FY die längere der beiden Ausdehnungen des ersten Rasterelementes beschreibt, gegeben ist als

$$\frac{FY \cdot s \cdot L}{(FY+0.5D) \cdot s - (FY-X) \cdot L} > f > \frac{FY \cdot s \cdot L}{(FY+D) \cdot s - (FY-X) \cdot L}$$

so daß eine Defokussierung auftritt.

**4.** Beleuchtungssystem nach einem der Ansprüche 1 bis 3, **dadurch gekennzeichnet, daß**
das Beleuchtungssystem eine Kollektoreinheit (120) vor dem ersten optischen Element (102) mit ersten Rasterelementen (1) umfaßt.

**5.** Beleuchtungssystem nach einem der Ansprüch 1 bis 4,
**dadurch gekennzeichnet, daß**
das System wenigstens einen Spiegel (106, 108, 110), der dem zweiten optischen Element (104) nachgeordnet ist, umfaßt, wobei der wenigstens eine Spiegel (106, 108, 110) eine Ebene, die in oder in der Nähe des zweiten optischen Elementes angeordnet ist, in die Austrittspupille (112) abbildet.

**6.** Belechtungssystem nach einem der Ansprüche 1 bis 5
**dadurch gekennzeichnet, daß**
die zweiten Rasterelemente (3) und wenigstens ein Spiegel (106, 108, 110), der dem zweiten optischen Element nachgeordnet ist, die zugeordneten ersten Rasterelemente (1) in die Objektebene (114) abbilden.

**7.** EUV-Projektionsbelichtungsanlage für die Mikrolithographie mit

- einer Quelle zur Erzeugung von EUV-Strahlung
- einem Beleuchtungssystem gemäß einem der Ansprüche 1 bis 6 mit einer Austrittspupille, welches die von der Quelle erzeugte Strahlung teilweise sammelt und zur Beleuchtung eines Ringfeldes weiterleitet
- einer strukturtragenden Maske auf einem Trägersystem, wobei diese Maske in der Ebene des Ringfeldes liegt
- einer Projektionseinrichtung, insbesondere einem Projektionsobjektiv mit einer Eintrittspupille, die mit der Austrittspupille des Beleuchtungssystems zusammenfällt, wobei dieses Projektionsobjektiv den beleuchteten Teil der strukturtragenden Maske in ein Bildfeld abbildet
- ein lichtsensitives Substrat auf einem Trägersystem, wobei dieses lichtsensitive Substrat in der Ebene des Bildfeldes der Projektionseinrichtung liegt.

**8.** Verfahren zur Herstellung von mikroelektronischen Bauelementen, insbesondere Halbleiterchips mit einer EUV-Projektionsbelichtungsanlage gemäß Anspruch 7.

Fig.1

Apertur
Feldwabe

1

Apertur
Pupillenwabe

3

α

σ

X'

σ'

κD

X

α'

100

s

s'

z

Bildebene
Lichtquellenbild

Fig.2

## Fig.3

Fig.4

1m

Fig.5